# EUROPEAN PATENT SPECIFICATION

(11) **EP 0 305 300 B1**
(45) Date of publication and mention of the grant of the patent: **24.04.1996**
(21) Application number: 88402177.5
(22) Date of filing: 29.08.1988
(51) Int. Cl.: H01L 39/24, C04B 35/00

(54) **A method for producing a superconducting article**
Verfahren zur Herstellung eines supraleitenden Gegenstandes
Procédé pour la fabrication d'un objet supraconducteur

(30) Priority: 28.08.1987 JP 214440/87
(43) Date of publication of application: 01.03.1989
(73) Proprietor: SUMITOMO ELECTRIC INDUSTRIES LIMITED, Osaka-shi, Osaka 541 (JP)
(72) Inventor: Yamaguchi, Takeshi c/o Itami Works of Sumitomo, Itami-shi Hyogo (JP); Itozaki, Hideo c/o Itami Works of Sumitomo, Itami-shi Hyogo (JP); Yazu, Shuji c/o Itami Works of Sumitomo, Itami-shi Hyogo (JP); Jodai, Tetsuji c/o Itami Works of Sumitomo, Itami-shi Hyogo (JP)
(74) Representative: Phélip, Bruno

(56) References cited:
- EP-A- 0 296 719
- DE-A- 3 600 575
- JAPANESE JOUNAL OF APPLIED PHYSICS, vol. 26, no. 8, 8, August 1987, pages L1310-L1312, Tokyo, JA; K. MATSUZSKI et al.: "High Tc-Superconductor Prepared by Oxidization of a Liquid-Quenched Yb1Ba2Cu3 Alloy Foil in Air"
- APPLIED PHYSICS LETTERS, vol. 51, no. 7, 17 August 1987, pages 538-539, New York, US; R. HALDAR et al.: "EuBa2Cu3Ox produced by oxidation of a rapidly solidified precursor alloy: An alternative preparation method for high Tc ceramic superconductors"
- PATENT ABSTRACTS OF JAPAN, vol. 6, no. 230 (E-142)(1108), 16 November 1982 & JP-A-57 132 381
- ADVANCED CERAMIC MATERIALS - CERAMIC SUPERCONDUCTORS, vol. 2, no. 3B, July 1987, pages 388-400, Westerville, Ohio, US; R.W. MCCALLUM et al.: "Problems in the production of YBa2Cu3Ox superconducting wire"
- JAPANESE JOURNAL OF APPLIED PHYSICS, vol. 27, no. 2, February 1988, pages L209-L210
- APPLIED PHYSICS LETTERS, vol. 52, no. 20, May 1988, pages 1738-1740
- J. ELECTROCHEM. SOC., vol. 134, no. 6, Jun. 1987, pages 1588-1589
- J. ELECTROCHEM. SOC., vol. 134, no. 10, Oct. 1987, pages 2635-2636
- JAPANESE JOURNAL OF APPLIED PHYSICS, vol. 26, no. 4, April 1987, pages L334-L336

## Description

The present invention relates to a method of producing a superconducting article such as a superconducting wire. More particularly, it relates to a novel method of producing a superconducting article comprising a core body composed of an alloy and a surface layer composed of a superconducting material supported on or surrounding the core body.

Under the superconducting condition, the electric resistance becomes zero and the perfect diamagnetism is observed. Thus, under the superconducting condition, electric current of a very high current density can be delivered without any loss of power.

Realization of superconducting coils which permit to generate a very high magnetic field is expected to accelerate development in the field of fusion power generation as well as in the field of MHD power generation or motor-generators. The development of superconducting coils is demanded also in the other industrial fields such as electric power reservation system; transportation systems such as magnetic levitation trains or magnetically propelling ships; medical appliances such as a high-energy beam radiation unit; or scientific instruments such as NMR.

In addition to the abovementioned electric power applications, the superconducting materials can be used in the field of electronics, for example, as a device using the Josephson effect in which quantum efficiency is observed macroscopically when an electric current is passed through a weak junction arranged between two superconductors. Tunnel junction type Josephson device which is a typical application of the Josephson effect is expected to be a high-speed and low-power consuming switching device owing to smaller energy gap of the superconducting material. It is also expected to utilize the Josephson device as a high sensitive sensor or detector for sensing very weak magnetic field, microwave, radiant ray or the like since variation of electromagnetic wave or magnetic field is reflected in variation of Josephson effect and can be observed as a quantum phenomenon precisely. Development of the superconducting devices is also demanded in the field of high-speed computers in which the power consumption per unit area is reaching to the upper limit of the cooling capacity with increment of the integration density in order to reduce energy consumption,

However, the critical temperature could not exceed 23.2·K of Nb₃Ge which was the the highest Tc for the past ten years.

The possibility of an existence of new types of superconducting materials having much higher Tc was revealed by Bednorz and Müller, who discovered a new oxide type superconductor in 1986 [Z. Phys. B64 (1986) 189].

It had been known that certain ceramic materials of compound oxides exhibit the property of superconductivity. For example, U. S. patent No. 3,932,315 discloses Ba-Pb-Bi type compound oxide which shows superconductivity and Japanese patent laid-open No. 60-173,885 discloses that Ba-Bi type compound oxides also show superconductivity. These superconductors, however, possess rather lower transition temperatures of about 10 K and hence usage of liquidized helium (boiling point of 4.2 K) as cryogen is indispensable to realize superconductivity.

The new type compound oxide superconductor discovered by Bednorz and Müller is represented by [La, Sr]₂CuO₄ which is called the K₂NiF₄-type oxide having a crystal structure which is similar to known perovskite type oxides. The K₂NiF₄-type compound oxides show such higher Tc as 30 K, which are extremely higher than known superconducting materials.

It was also reported that C. W. Chu et al discovered, in the United States of America, another superconducting material so called YBCO type represented by YBa₂Cu₃O₇₋ₓ having the critical temperature of in the order of 90 K in February 1987. Still other type new superconducting materials which were reported recently are a compound oxide of Bi-Sr-Ca-Cu-O system and Tl-Ba-Ca-Cu-O system which exhibit such high Tc as more than 100 K and which are chemically more stable than the abovementioned YBCO type compound oxide or the like.

And hence, the possibility of an existence of high-temperature superconductors has burst onto the scene.

However, these new type superconducting materials are ceramic materials of compound oxides which do not possess such a high plasticity as well-known metal type superconducting materials such as Ni-Ti alloy. In fact, they are produced by a sintering technique in which a compact of powder material is sintered in a furnace. However, the sintered articles are fragile and easily brake even under a very weak mechanical stress, so that they cannot or are difficult to be shaped or deformed into a desired shape such as wire by the conventional plastic deformation techniques. In order to realize a reliable and practical superconducting structure, it is indispensable that the structure possesses enough strength and tenacity which is sufficient to endure bending force during usage.

Further superconducting materials and methods of preparing such materials are described in the following documents :
- Japanese Journal of Applied Physics, vol. 26, N° 8, August 1987, pages L1310-L1312, Tokyo, JP, "High T_{c} Superconductor Prepared by Oxidization of a Liquid-Quenched Yb₁Ba₂Cu₃ Alloy Foil in Air" teaches an Yb₁Ba₂Cu₃ alloy foil with a nonequilibrium structure including an amorphous phase was prepared by splat-quenching. Heating of the alloy foil in air resulted in the structural change to a crystalline metallic phase at about 490 K, followed by the oxide formation qf Yb₁Ba₂Cu₃O_{6.8} at temperatures above about 540 K. The Yb₁Ba₂Cu₃O_{6.8} prepared by oxidization of the liquid-quenched alloy foil was found to exhibit high T_{c} superconductivity with onset at 91 K and zero resistance at 85 K.
- Applied Physics Letters, vol. 51, N° 7, 17 August 1987, pages 538-539, New York, US, "EuBa₂Cu₃Oₓ produced by oxidation of a rapidly solidified precursor alloy : An alternative preparation method for high T_{c} ceramic superconductors" teaches that Eu₁Ba₂Cu₃O₇ had been prepared by first combining three metals into an alloy by rapid solidification processing, followed by oxidation to form the cuprate. The superconducting properties of the oxidized alloys are similar to those of EuBa₂Cu₃Oₓ prepared by the standard ceramic reaction route.
- From Patent Abstracts of Japan, vol. 6, N° 230 (E-142) (1108), 16 November 1982, it is known to convert a substrate of any material into a usable one by a method wherein a combination of one or two oxide constituting a superconductive compound and a high melting point metal undergoes transformation why they are exposed to a high energy laser beam. The combination locally heated along the pattern results in the formation of a thin film of a superconductive compound (Nb₁-ₓVₓ)₃Ge_{1-y}Si(1≥y≥0) and an oxide layer of a high melting point metal Nb₁₋ₓVₓ.
- DE-A-36.00.575 describes a method of forming an oxide film on an element of the platinum group. This film is formed by implanting oxygen ions in the surface of that metal.
- Japanese Journal of Applied Physics, vol. 27,° 2, February 1988, pages L209-L210, "A New High-T_{c} Oxide Sperconductor without a Rare Earth Element" teaches that a new high-T_{c} oxide superconductor of the Bi-Sr-Ca-Cu-O system without any rare earth element was discovered. The oxide BiSrCaCu₂Oₓ has T_{c} of about 105 K, higher than that of YBa₂Cu₃O₇ by more than 10 K. In this oxide, the coexistence of Sr and Ca is necessary to obtain high T_{c}.
- Applied Physics Letters, vol. 52, N° 20, May 1988, pages 1738-1740, "New 120 K Ti-Ca-Ba-Cu-O superconductor", teaches that the Ti-Ca-Ba-Cu-O superconductor can be prepared in a molten state at a relatively low temperature (900-950°C). Appropriate amounts of Ti₂o₃, CaO and BaCu₃O₄ (or Ba₂Cu₃O₅) are completely mixed and ground, and pressed into a pellet. The pellet is then put into a tube furnace, which has been heated to 880-920°C and is heated for 3-5 min in flowing oxygen. The sample is then furnace cooled to room temperature in about 1 h. This preparation slightly suppresses the transition temperature, but does not destroy superconductivity.
- Journal of The Electrochemical Society, vol. 134, N° 6, June 1987, pages 1588-1589, "Formation of Perovskite Surface Layers by Oxidation of Cu-La-Sr alloys" teaches that perovskite-type crystal structures composed of La-Cu oxides substituted with small amounts of alkaline earth cations have exceptionally high superconducting critical temperatures. To fabricate the perovskite phase, appropriate quantities of Cu, La and Sr were melted together in a Mo crucible under helium in order to form an alloy of composition 62 at.% La, 5 at.% Sr and 33 at.% Cu (the metallic composition of La_{1.85}Sr_{0.15}CuO₄). Droplets of the melt were quenched on a chill plate to inhibit phase separation.
- Journal of The Electrochemical Society, vol. 134, N° 10, October 1987, pages 2635-2636, "Direct Synthesis of a Metal/Superconducting Oxide Composite by Oxidation of a Metallic Precursor" teaches that although superconducting oxides produced by oxidation of metallic precursors are dense, they are still brittle. To help overcome the inherent brittleness of these oxides, noble metals were added to the metallic precursors to yield directly, after oxidation, a metal/superconducting oxide composite.
- Japanese Journal of Applied Physics, vol. 26, N° 4, April 1987, pages L334-L336, "Preparation of a High T_{c} Superconductor by Oxidization of an Amorphous La_{1.8}Sr_{0.2}CU Alloy Ribbon in Air" teaches that a ductile La_{1.8}Sr_{0.2}CU amorphous alloy with a long ribbon shape was prepared by melt spinning. Oxidization of the amorphous alloy ribbon at 1173 K for 1.2 ks in air resulted in formation of a tetragonal (La_{1.8}Sr_{0.2}CU)ₓO_{y} oxide. Furthermore, the oxide ribbon was found to exhibit high T_{c} superconductivity with onset at 36 K, midpoint at 22 K and zero resistance at 9 K.
- EP-A-0.296.719 falling within the terms of Article 54(3) EPC describes a method of producing superconductor films on a variety of substrates and, more particularly, a patterned superconductor film on a planar substrate. The basic process includes the steps of : 1) depositing a metal film of superconductor precursor elements on a substrate ; 2) patterning the metal film ; and 3) oxidizing the metal film to form a superconductor film. Because the process separates the metal precursor film formation, patterning, and oxidation steps, each of the steps can be individually optimized.

Taking the above mentioned situation into consideration, the present inventors have proposed a process for manufacturing a ceramic wire by the steps comprising filling a metal pipe with a material powder of ceramic, performing plastic deformation of the metal pipe filled with the ceramic metal powder to reduce the cross section of the metal pipe, and then subjecting the deformed metal pipe to heat-treatment to sinter the ceramic material powder in the metal pipe in European patent applications EP-A-0 281 444 (N°. 88.400.267), EP-A-0 281 474 (N°.88.400.466.4) and EP-A-0 290 331 (N°. 88.401.064.6).

These solutions are themselves satisfactory but the present inventors have continued to develop another process which can produce the superconductor of compound oxide more simply and completed the present invention.

Therefore, an object of the present invention is to provide a new and simple method of manufacturing a superconductor.

The present invention provides a method of producing a superconducting article made of copper-containing metal alloy that functions as a by-pass of electric current in an emergency and having a superconducting copper-containing surface layer composed of a superconducting copper-containing compound oxide, consisting essentially of the steps of :
preparing a metal powder mixture of constituent metal elements of the superconducting copper-containing compound oxide except for oxygen,
melting the metal powder mixture at a temperature which is higher than 1,000°C to produce a core of copper-containing metal alloy, and
oxidizing a surface of said core of copper-containing metal alloy to such an extent that an outer surface of said core of metal alloy is converted to a superconducting copper-containing compound oxide composed of the constituent metal elements and oxygen to produce a superconducting surface layer while a core of copper-containing metal alloy remains which functions as a by-pass of electric current when there is a break in the superconducting surface layer.

The term " an alloy consisting of metal elements which are constituent elements of a superconducting compound oxide " means such a metallurgical mixture as composed of all elements of a superconducting compound oxide to be produced except oxygen, in other words, an alloy of metal elements of the superconducting compound oxide to be produced. For instance, in a case that a surface layer of a superconducing compound oxide of Y-Ba-Cu-O system is produced, an alloy consisting of Y-Ba-Cu is used. For La-Ba-Cu-O system and La-Sr-Cu-O system, alloys consisting of La-Ba-Cu and La-Sr-Cu are used respectively. An atomic ratio of these metal elements in the alloy should be adjusted to a value which corresponds to an atomic ratio of these metal elements in the compound oxide to be produced on tile surface of the alloy.

Since these metal elements possess metallic properties, the alloy of these metal elements can be prepared by any one of the conventional metallurgical techniques for producing metal alloys which are well-known. For example, an alloy of Y-Ba-Cu for producing a surface layer of a compound oxide of Y-Ba-Cu-O system is prepared as following:

At first, commercially available metal powders of yttrium, barium and copper are mixed with an atomic ratio of Y:Ba:Cu = 1:2:3 in ethanol in non-oxidative atmosphere or under vacuum. The resulting mixture of metal powders is melt at a temperature which is higher than 1,000 °C This stage of fusion of metal elements is carried out in non-oxidative atmosphere or under vacuum in order to prevent oxidation of the metal elements which will deteriorate mechanical strength of the resulting alloy.

The alloy thus obtained possess properties as a metal, so that alloy can be shaped into a desired configuration such as a wire, a stripe, a band, a coil, a rod, a yoke or the like by any one of the conventional metal workings such as wire drawing technique, press molding or forging or the like. For example, a rod or a bar is cut out of an ingot which is produced by casting molten alloy thus obtained and is drawn through a wire-drawing machine into a shape of a wire or a tape which will be used as a core body in next stage.

According to the present invention, a surface of the core body of alloy thus obtained is oxidized so that the surface of alloy is converted to an oxide of the metal elements. The oxidation of the surface of alloy can be effected by any one of known oxidizing techniques. For example, the alloy is heated by means of laser beam, high-frequency wave, oxidizing flame or the like in'an oxidative atmosphere to produce a compound oxide layer on a surface of the alloy. The oxidation of the surface of alloy can be effected also by oxygen ion beam bombarding or doping technique in a vacuum chamber as well as by means of oxidizing agents. In a case of an elongated article such as a wire or a tape, the oxidation can be carried out continuously. The oxidation of alloy must be effected to such a manner that a layer of compound oxide having a certain depth is produced on a surface of the alloy.

The resulting product according to the present invention comprises a core body consisting of alloy which possesses metallic properties and an outer oxide layer which has a superconducting property. Thus, the core body of alloy functions as a support for the outer oxide layer.

As the compound oxide which can be prepared by the present invention, the following systems of compound oxides are mentioned:

(1) a compound oxide represented by the general formula:

α_{w}βₓγ_{y}O_{z}

in which α stands for an element selected from IIa group of the Periodic Table, β stands for at least one of elements selected from IIIa group of the Periodic Table, and γ stands for an element selected from a group comprising Ib, IIb, IIIb, IVa and VIIIa groups of the Periodic Table and w, x, y and z satisfy respective ranges of 1 ≤ w ≤ 5,1 ≤ x ≤ 5,1 ≤ y ≤ 15,1 ≤ z ≤ 20. The element α is preferably Ba or Sr, the element β is preferably at least one element selected from a group comprising Y, La, Gd, Dy, Ho, Er, Tm, Yb, Nd, Sm, Eu and Lu and the element γ is preferably Cu. The other elements selected from a group comprising Al, Fe, Co, Ni, Zn, Ag and Ti can be added to the system in addition to the elements α,β and γ.

Selection of the atomic ratio between α and β depends on a combination of these elements and is preferably made in the following range:
- Y/(Y+Ba):: 0.06 to 0.94, preferably 0.1 to 0.4
- Ba/(La+Ba):: 0.04 to 0.96, preferably 0.08 to 0.45
- Sr/(La+Sr):: 0.03 to 0.95, preferably 0.05 to 0.1

In a preferred system, the element α is Ba, the element β is at least one element selected from a group comprising Y, La, Gd, Dy, Ho, Er, Tm, Yb, Nd, Sm, Eu and Lu and the element γ is Cu and an atomic ratio of Ba: β: Cu is 2 : 1: 3. In this system, the converted compound oxide of the metal elements which is formed on the surface of the alloy is represented by the general formula:

Ln₁Ba₂Cu₃O_{7-δ}

in which Ln stands for at least one element selected from a group comprising Y, La, Gd, Dy, Ho, Er, Tm, Yb, Nd, Sm, Eu and Lu and δ satisfies a range of 0 < δ < 1.

Thus, the preferable compound oxides are Y-Ba-Cu-O system including the following special cases:
Y₁Ba₂Cu₃O_{7-δ}, Ho₁Ba₂Cu₃O_{7-δ}, Lu₁Ba₂Cu₃O_{7-δ},
Sm₁Ba₂Cu₃O_{7-δ}, Nd₁Ba₂Cu₃O_{7-δ}, Gd₁Ba₂Cu₃O_{7-δ} ,
Eu₁Ba₂Cu₃O_{7-δ}, Er₁Ba₂Cu₃O_{7-δ}, Dy₁Ba₂Cu₃O_{7-δ} ,
Tm₁Ba₂Cu₃O_{7-δ}, Yb₁Ba₂Cu₃O_{7-δ}, La₁Ba₂Cu₃O_{7-δ} ,
in which x is a number which satisfies a range of 0 < x < 1.

The above-mentioned compound oxides preferably possess perovskite type or quasi-perovskite type crystal structure. The term quasi-perovskite type means a structure which can be considered to have such a crystal structure that is similar to perovskite-type oxides and includes an orthorhombically distorted perovskite or a distorted oxygen-deficient perovskite or the like.

(2) a compound oxide represented by the general formula:

(M, Sr)₂CuO_{4-δ}

in which M stands for Y or La and δ satisfies a range of 0 < δ < 1.

(3) a compound oxide represented by the general formula:

(α₁₋ₓβₓ)Cu_{y}O_{z}

in which α and β means the same definition as above, x is an atomic ratio of β with respect to (α+β) and has a range of 0.1 ≤ x ≤ 0,9, and y and z are respective atomic ratios with respect to (α₁₋ₓβₓ) which is considered to be equal to I and each satisfies ranges of 0.4 ≤ y ≤ 3.0 and 1 ≤ z ≤ 5 respectively.

(4) a compound oxide represented by the general formula:

Θ₄(Φ_{1-q}, Ca_{q})ₘCuₙOₚ₊ᵣ

in which Θ stands for Bi or T1, Φ stands for Sr when Θ is Bi and stands for Ba when Θ is T1, m and n are numbers each satisfying a range of 6 ≤ m ≤ 10 and 4 ≤ n ≤ 8 respectively, p = (6+m+n), q is a number which satisfies a range of 0 < q < 1, and r is a number which satisfies a range of -2 ≤ r ≤ +2. This system is considered to be a single phase of the following compound oxide or a mixed phase consisting mainly thereof:
Bi₄Sr₄Ca₄Cu₆O₂₀₋ᵣ, Bi₂Sr₂Ca₂Cu₃O₁₀₋ᵣ or
Tl₄Ba₄Ca₄Cu₆O₂₀₋ᵣ, Tl₂Ba₂Ca₂Cu₃O₁₀₋ᵣ,
in which r is a number which satisfies a range of -2 ≤ r ≤ +2.

When a surface layer of a compound oxide of Bi-Sr-Ca-Cu-O system is prepared, an alloy consisting of Bi, Sr, Ca and Cu with an atomic ratio of Bi : Sr: Ca : Cu = 2 : 2: 2 ; 3 is preferably used and when a surface layer of a compound oxide of Tl-Ba-Ca-Cu-O system is prepared, an alloy consisting of Tl, Ba, Ca and Cu with an atomic ratio of Tl ; Ba : Ca : Cu = 2 : 2: 2: 3 is preferably used.

According to the method of the present invention, the resulting article has a compound oxide layer which possesses the superconducting property on a surface of a core body of alloy which functions as a mechanical support and a by-pass of electric current when the superconductivity break.

The superconducting article obtained is advantageously usable in the field of electric circuits which control electric signals precisely,

Now, an embodiment of the method according to the present invention will be described by Example, but the scope of the present invention as claimed should not be limited thereto.

### Example 1

Commercially available metal powders of yttrium, barium and copper are mixed with an atomic ratio of Y:Ba:Cu = 1:2:3 in ethanol in nitrogen gas atmosphere. The resulting mixture of metal powders is melt in a platinum crucible at a temperature which is higher than 1,500 °C for 2 hours in vacuum

From the resulting alloy, three wires (sample No. 1, 2 and 3) each having a length of 30 cm and a diameter of 2 mm, 3 mm and 5 mm respectively are prepared by means of roller dies and then heated at 950°C for 5 hours in an oxygen atmosphere of 10⁵ Pa (1 atm). After the heat-treatment complete, the wires are cooled down slowly at a cooling rate of 10°C/min.

After electrodes are connected on a surface of each wire with a silver paste, the wire is immersed in liquidized helium and then the temperature is arisen gradually to measure the temperature dependency of the superconductivity. Electric resistance is determined by common four probe method and the temperature is determined by a calibrated Au(Fe)Ag thermocouple.

The result is summarized in Table 1.

**Table 1**

| Sample No. (Diameter) | Tc (K) | Tci (K) |
|---|---|---|
| 1 (2mm) | 96 | 87 |
| 2 (3mm) | 101 | 94 |
| 3 (5 mm) | 98 | 92 |

Note:
Tc: the critical temperature of superconductivity.
Tci: The terminal point of the phase transition where the perfect zero resistance is realized.

## Claims

1. A method of producing a superconducting article made of copper-containing metal alloy that functions as a by-pass of electric current in an emergency and having a superconducting copper-containing surface layer composed of a superconducting copper-containing compound oxide, consisting essentially of the steps of:
preparing a metal powder mixture of constituent metal elements of the superconducting copper-containing compound oxide except for oxygen,
melting the metal powder mixture at a temperature which is higher than 1,000°C to produce a core of copper-containing metal alloy, and
oxidizing a surface of said core of copper-containing metal alloy to such an extent that an outer surface of said core of metal alloy is converted to a superconducting copper-containing compound oxide composed of the constituent metal elements and oxygen to produce a superconducting surface layer while a core of copper-containing metal alloy remains which functions as a by-pass of electric current when there is a break in the superconducting surface layer.

2. The method according to claim 1, wherein the oxidation of the surface of said core of metal alloy is effected by heating the outer surface of said core of metal alloy in an oxidative atmosphere.

3. The method according to claim 1, wherein the oxidation of the surface of said core of metal alloy is effected by irradiating the outer surface of said core of metal alloy with a laser beam in the presence of oxygen.

4. The method according to claim 1, wherein the oxidation of the surface of said core of metal alloy is effected by irradiating the outer surface of said core of metal alloy with high-frequency waves in the presence of oxygen.

5. The method according to claim 1, wherein the oxidation of the surface of said core of metal alloy is effected by irradiating the outer surface of said core of metal alloy with oxygen ion beam bombardment in a vacuum chamber.

6. The method according to claim 1, wherein the oxidation of the surface of said core of metal alloy is effected by burning the outer surface of said core of metal alloy with an oxidizing flame.

7. The method according to claim 1, wherein said superconducting article has a form of an elongated shape.

8. The method according to claim 1, wherein said core of metal alloy consists of metal elements comprising Ba, at least one element selected from Y, La, Gd, Dy, Ho, Er, Tm, Yb, Nd, Sm, Eu, Lu and Cu, and wherein said compound oxide formed on the surface of said core of metal alloy is a compound oxide represented by the general formula:
Ln₁Ba₂Cu₃O_{7-δ}
in which Ln stands for at least one element selected from a group comprising Y, La, Gd, Dy, Ho, Er, Tm, Yb, Nd, Sm, Eu and Lu, and δ satisfies a range of 0 < δ < 1.

9. The method according to claim 1, wherein said core of metal alloy consists of Sr, Y or La, and Cu and wherein said compound oxide formed on the surface of said core of metal alloy is a compound oxide represented by the general formula:
(M, Sr)₂CuO_{4-δ}
in which M stands for Y or La, and δ satisfies a range of 0 < δ < 1.

10. The method according to claim 1, wherein said core of metal alloy consists of Bi, Sr, Ca and Cu having the atomic ratios of Bi:Sr:Ca:Cu of 2:2:2:3, and wherein said compound oxide formed on the surface of said core of metal alloy is a compound oxide represented by the general formula:
Bi₄(Sr_{1-q},Ca_{q})ₘCuₙOₚ₊ᵣ
in which "m" and "n" are numbers each satisfying a range of 6 ≤ m ≤ 10 and 4 ≤ n ≤ 8, respectively, p = (12+m+n), q is a number which satisfies a range of 0 < q < 1, and r is a number which satisfies a range of -2 ≤ r ≤ +2.

11. The method according to claim 1, wherein said core of metal alloy consists of Tl, Ba, Ca and Cu having the atomic ratios of Tl:Ba:Ca:Cu of 2:2:2:3, and wherein said compound oxide formed on the surface of said core of metal alloy is a compound oxide represented by the general formula:
Tl₄(Ba_{1-q}Ca_{q})ₘCuₙOₚ₊ᵣ
in which "m" and "n" are numbers each satisfying a range of 6 ≤ m ≤ 10 and 4 ≤ n ≤ 8, respectively, p = (12+m+n), q is a number which satisfies a range of 0 < q < 1, and r is a number which satisfies a range of -2 ≤ r ≤ +2.

12. A method for producing a superconducting article having a core of metal alloy consisting of Y, Ba and Cu that functions as a by-pass of electric current in an emergency and a superconducting compound oxide layer formed on an outer surface of said core, consisting essentially of the steps of:
preparing a metal powder mixture Y, Ba and Cu having atomic ratios of Y:Ba:Cu of 1:2:3,
melting the metal powder mixture at a temperature which is higher than 1,500°C in a vacuum to produce said core of metal alloy of Y, Ba and Cu, and
oxidizing a surface of said core of metal alloy of Y, Ba and Cu at 950°C for more than 5 hours in an oxygen gas atmosphere of 10⁵ Pa (1 atm), so that an outer surface of said core of metal alloy of Y, Ba and Cu is converted to a compound oxide represented by the general formula:
Y₁Ba₂Cu₃O_{7-δ}
in which δ satisfies a range of 0 < δ < 1.

13. The method according to claim 12, wherein the oxidized core is cooled slowly at a cooling rate of 10°C/min.

## Patentansprüche

1. Verfahren zur Herstellung eines supraleitenden Gegenstands, der aus einer kupferhaltigen Metallegierung besteht, die in einem Notfall als Nebenschluß für elektrischen Strom fungiert, und eine supraleitende kupferhaltige Oberflächenschicht aufweist, die aus einem supraleitenden kupferhaltigen zusammengesetzten Oxid besteht, wobei das Verfahren im wesentlichen aus den Schritten besteht:
Herstellen eines Metallpulvergemischs aus den das supraleitende kupferhaltige zusammengesetzte Oxid bildenden Metallelementen, abgesehen von Sauerstoff;
Schmelzen des Metallpulvergemischs bei einer Temperatur, die höher als 1000°C ist, unter Bildung eines Kerns aus kupferhaltiger Metallegierung und
Oxidieren einer Oberfläche des Kerns aus kupferhaltiger Metallegierung in einem solchen Ausmaß, daß eine äußere Oberfläche des Kerns aus Metallegierung in ein supraleitendes kupferhaltiges zusammengesetztes Oxid umgewandelt wird, das aus den konstituierenden Metallelementen und Sauerstoff besteht, unter Bildung einer supraleitenden Oberflächenschicht, wobei ein Kern aus kupferhaltiger Metallegierung übrigbleibt, der als Nebenschluß für elektrischen Strom fungiert, wenn es in der supraleitenden Oberflächenschicht eine Unterbrechung gibt.

2. Verfahren gemäß Anspruch 1, wobei die Oxidation der Oberfläche des Kerns aus der Metallegierung durch Erhitzen der äußeren Oberfläche des Kerns aus der Metallegierung in einer oxidierenden Atmosphäre bewirkt wird.

3. Verfahren gemäß Anspruch 1, wobei die Oxidation der Oberfläche des Kerns aus der Metallegierung durch Bestrahlen der äußeren Oberfläche des Kerns aus der Metallegierung mit einem Laserstrahl in Gegenwart von Sauerstoff bewirkt wird.

4. Verfahren gemäß Anspruch 1, wobei die Oxidation der Oberfläche des Kerns aus der Metallegierung durch Bestrahlen der äußeren Oberfläche des Kerns aus der Metallegierung mit hochfrequenten Wellen in Gegenwart von Sauerstoff bewirkt wird.

5. Verfahren gemäß Anspruch 1, wobei die Oxidation der Oberfläche des Kerns aus der Metallegierung durch Beschuß der äußeren Oberfläche des Kerns aus der Metallegierung mit einem Sauerstoffionenstrahl in einer Vakuumkammer bewirkt wird.

6. Verfahren gemäß Anspruch 1, wobei die Oxidation der Oberfläche des Kerns aus der Metallegierung durch Brennen der äußeren Oberfläche des Kerns aus der Metallegierung mit einer oxidierenden Flamme bewirkt wird.

7. Verfahren gemäß Anspruch 1, wobei der supraleitende Gegenstand eine längliche Form hat.

8. Verfahren gemäß Anspruch 1, wobei der Kern aus der Metalllegierung aus Metallelementen besteht, die Ba, wenigstens ein Element, das aus Y, La, Gd, Dy, Ho, Er, Tm, Yb, Nd, Sm, Eu, Lu ausgewählt ist, und Cu umfassen und wobei das auf der Oberfläche des Kerns aus der Metallegierung gebildete zusammengesetzte Oxid ein zusammengesetztes Oxid ist, das durch die allgemeine Formel:
Ln₁Ba₂Cu₃O_{7-δ}
dargestellt wird, wobei Ln für wenigstens ein Element steht, das aus einer Gruppe ausgewählt ist, die Y, La, Gd, Dy, Ho, Er, Tm, Yb, Nd, Sm, Eu und Lu umfaßt, und δ in einem Bereich von 0 < δ < 1 liegt.

9. Verfahren gemäß Anspruch 1, wobei der Kern aus der Metalllegierung aus Sr, Y oder La sowie Cu besteht und wobei das auf der Oberfläche des Kerns aus der Metallegierung gebildete zusammengesetzte Oxid ein zusammengesetztes Oxid ist, das durch die allgemeine Formel:
(M,Sr)₂CuO_{4-δ}
dargestellt wird, wobei M für Y oder La steht und δ in einem Bereich von 0 < δ < 1 liegt.

10. Verfahren gemäß Anspruch 1, wobei der Kern aus der Metalllegierung aus Bi, Sr, Ca und Cu in einem Atomverhältnis von Bi:Sr:Ca:Cu von 2:2:2:3 besteht und wobei das auf der Oberfläche des Kerns aus der Metallegierung gebildete zusammengesetzte Oxid ein zusammengesetztes Oxid ist, das durch die allgemeine Formel:
Bi₄(Sr_{1-q},Ca_{q})ₘCuₙOₚ₊ᵣ
dargestellt wird, wobei "m" und "n" Zahlen sind, die in einem Bereich von 6 ≤ m ≤ 10 bzw. 4 ≤ n ≤ 8 liegen, p gleich (12+m+n) ist, q eine Zahl ist, die in einem Bereich von 0 < q < 1 liegt, und r eine Zahl ist, die in einem Bereich von -2 ≤ r ≤ +2 liegt.

11. Verfahren gemäß Anspruch 1, wobei der Kern aus der Metalllegierung aus Tl, Ba, Ca und Cu in einem Atomverhältnis von Tl:Ba:Ca:Cu von 2:2:2:3 besteht und wobei das auf der Oberfläche des Kerns aus der Metallegierung gebildete zusammengesetzte Oxid ein zusammengesetztes Oxid ist, das durch die allgemeine Formel:
Tl₄(Ba_{1-q}Ca_{q})ₘCuₙOₚ₊ᵣ
dargestellt wird, wobei "m" und "n" Zahlen sind, die in einem Bereich von 6 ≤ m ≤ 10 bzw. 4 ≤ n ≤ 8 liegen, p gleich (12+m+n) ist, q eine Zahl ist, die in einem Bereich von 0 < q < 1 liegt, und r eine Zahl ist, die in einem Bereich von -2 ≤ r ≤ +2 liegt.

12. Verfahren zur Herstellung eines supraleitenden Gegenstands, der einen Kern aus einer Metallegierung, die aus Y, Ba und Cu besteht, welcher in einem Notfall als Nebenschluß für elektrischen Strom fungiert, und eine auf einer äußeren Oberfläche des Kerns gebildete Schicht aus einem supraleitenden zusammengesetzten Oxid aufweist, wobei das Verfahren im wesentlichen aus den Schritten besteht:
Herstellen eines Metallpulvergemischs aus Y, Ba und Cu in einem Atomverhältnis von Y:Ba:Cu von 1:2:3;
Schmelzen des Metallpulvergemischs bei einer Temperatur, die höher als 1500°C ist, in einem Vakuum unter Bildung des Kerns aus der Metallegierung von Y, Ba und Cu und
Oxidieren einer Oberfläche des Kerns aus Metallegierung von Y, Ba und Cu bei 950°C während mehr als 5 Stunden in einer Sauerstoffatmosphäre von 10⁵ Pa (1 atm), so daß eine äußere Oberfläche des Kerns aus der Metallegierung von Y, Ba und Cu in ein zusammengesetztes Oxid umgewandelt wird, das durch die allgemeine Formel:
Y₁Ba₂Cu₃O_{7-δ}
dargestellt wird, wobei δ in einem Bereich von 0 < δ < 1 liegt.

13. Verfahren gemäß Anspruch 12, wobei der oxidierte Kern langsam mit einer Abkühlgeschwindigkeit von 10 grad/min abgekühlt wird.

## Revendications

1. Un procédé pour la fabrication d'un article supraconducteur réalisé en un alliage de métal contenant du cuivre qui fonctionne comme un shunt de courant électrique en cas d'urgence et ayant une couche de surface contenant du cuivre supraconductrice constituée d'un oxyde composé contenant du cuivre supraconducteur, qui comprend essentiellement les étapes consistant à:
préparer un mélange de poudre de métal des éléments de métaux constitutifs de l'oxyde composé contenant du cuivre supraconducteur à l'exception de l'oxygène,
fondre le mélange de poudre de métal à une température qui est supérieure à 1000°C pour produire un noyau d'alliage de métal contenant du cuivre, et
oxyder une surface dudit noyau d'alliage de métal contenant du cuivre selon une mesure telle qu'une surface extérieure dudit noyau d'alliage de métal est convertie en un oxyde composé contenant du cuivre supraconducteur constitué des éléments de métaux constitutifs et d'oxygène pour produire une couche de surface supraconductrice tandis qu'un noyau d'alliage de métal contenant du cuivre reste, lequel fonctionne comme un shunt de courant électrique lorsqu'il y a une rupture dans la couche de surface supraconductrice.

2. Le procédé selon la revendication 1, dans lequel l'oxydation de la surface dudit noyau d'alliage de métal est réalisée en chauffant la surface extérieure dudit noyau d'alliage de métal dans une atmosphère oxydante.

3. Le procédé selon la revendication 1, dans lequel l'oxydation de la surface dudit noyau d'alliage de métal est réalisée en irradiant la surface extérieure dudit noyau d'alliage de métal avec un faisceau laser en présence d'oxygène.

4. Le procédé selon la revendication 1, dans lequel l'oxydation de la surface dudit noyau d'alliage de métal est réalisée en irradiant la surface extérieure dudit noyau d'alliage de métal avec des ondes haute fréquence en présence d'oxygène.

5. Le procédé selon la revendication 1, dans lequel l'oxydation de la surface dudit noyau d'alliage de métal est effectuée en irradiant la surface extérieure dudit noyau d'alliage de métal avec un bombardement d'un faisceau d'ions oxygène dans une chambre sous vide.

6. Le procédé selon la revendication 1, dans lequel l'oxydation de la surface dudit noyau d'alliage de métal est réalisée en brûlant la surface extérieure dudit noyau d'alliage de métal avec une flamme oxydante.

7. Le procédé selon la revendication 1, dans lequel ledit article supraconducteur présente une forme allongée.

8. Le procédé selon la revendication 1, dans lequel ledit noyau d'alliage de métal se compose des éléments de métaux comprenant Ba, au moins un élément choisi parmi Y, La, Gd, Dy, Ho, Er, Tm, Yb, Nd, Sm, Eu, Lu et Cu et dans lequel ledit oxyde composé formé sur la surface dudit noyau d'alliage de métal est un oxyde composé représenté par la formule générale:
Ln₁Ba₂Cu₃O_{7-δ}
dans laquelle Ln représente au moins un élément choisi parmi le groupe comprenant Y, La, Gd, Dy, Ho, Er, Tm, Yb, Nd, Sm, Eu et Lu et δ satisfait la gamme de: 0 < δ < 1.

9. Le procédé selon la revendication 1, dans lequel ledit noyau d'alliage de métal se compose de Sr, Y ou La et Cu et dans lequel ledit oxyde composé formé sur la surface dudit noyau d'alliage de métal est un oxyde composé représenté par la formule générale:
(M, Sr)₂CuO_{4-δ}
dans laquelle M représente Y ou La et δ satisfait une gamme de 0 < δ < 1.

10. Le procédé selon la revendication 1, dans lequel ledit noyau d'alliage de métal se compose de Bi, Sr, Ca et Cu selon les rapports atomiques de Bi:Sr:Ca:Cu de 2:2:2:3 et dans lequel ledit oxyde composé formé sur la surface dudit noyau d'alliage de métal est un oxyde composé représenté par la formule générale:
Bi₄(Sr_{1-q},Ca_{q})ₘCuₙOₚ₊ᵣ
dans laquelle "m" et "n" sont des nombres satisfaisants chacun une gamme de 6 ≤ m ≤ 10 et 4 ≤ n ≤ 8, respectivement, p = (12+m+n), q est un nombre qui satisfait une gamme de 0 < q < 1, et r est un nombre qui satisfait une gamme de -2 ≤ r ≤ +2.

11. Le procédé selon la revendication 1, dans lequel ledit noyau d'alliage de métal se compose de Tl, Ba, Ca et Cu avec les rapports atomiques de Tl:Ba:Ca:Cu de 2:2:2:3, et dans lequel ledit oxyde composé formé sur la surface dudit noyau d'alliage de métal est un oxyde composé représenté par la formule générale:
Tl₄(Ba_{1-q}Ca_{q})ₘCuₙOₚ₊ᵣ
dans laquelle "m" et "n" sont des nombres satisfaisants chacun des gammes de 6 ≤ m ≤ 10 et 4 ≤ n ≤ 8, respectivement, p = (12+m+n), q est un nombre qui satisfait une gamme de 0 < q < 1, et r est un nombre qui satisfait une gamme de -2 ≤ r ≤ +2.

12. Un procédé pour la fabrication d'un article supraconducteur ayant un noyau d'alliage de métal se composant de Y, Ba et Cu qui fonctionne comme un shunt de courant électrique en cas d'urgence et une couche d'oxyde composé supraconductrice formée sur une surface extérieure dudit noyau comprenant essentiellement les étapes consistant à :
préparer un mélange de poudre de métal Y, Ba et Cu ayant des rapports atomiques de Y:Ba:Cu de 1:2:3,
fondre le mélange de poudre de métal à une température qui est supérieure à 1500°C sous vide pour produire ledit noyau d'alliage de métal de Y, Ba et Cu et
oxyder une surface dudit noyau d'alliage de métal de Y, Ba et Cu à 950°C pendant plus de 5 heures dans une atmosphère de gaz oxygène de 10⁵ Pa (1 atm.) si bien qu'une surface extérieure dudit noyau d'alliage de métal de Y, Ba et Cu est convertie en un oxyde composé représenté par la formule générale:
Y₁Ba₂Cu₃O₇₋δ
dans laquelle δ satisfait une gamme de 0 < δ < 1.

13. Le procédé selon la revendication 12, dans lequel le noyau oxydé est refroidi lentement à un taux de refroidissement de 10°C/min.
